# EUROPEAN PATENT APPLICATION

(11) **EP 1 976 109 A1**
(43) Date of publication of application: **01.10.2008**
(21) Application number: 07006796.2
(22) Date of filing: 31.03.2007
(51) Int. Cl.: H03D 3/00, H04N 5/21, H04B 1/10

(54) **Demodulator, method and receiver for demodulation**

(71) Applicant: SONY DEUTSCHLAND GMBH, 10785 Berlin (DE)
(72) Inventor: Spalink, Gerd, 70327 Stuttgart (DE); Eitel, Ben, 70327 Stuttgart (DE)
(74) Representative: Müller - Hoffmann & Partner

(57) **Abstract**

Demodulator for demodulating an input signal, comprising a complex-valued equalizer configured to equalize complex valued echoes within said input signal, wherein said complex-valued equalizer outputs a complex valued equalized signal; and a PLL circuit (209) including a PLL sub-unit (340), wherein said complex valued equalized signal (336) or a derivative thereof is used as input signal for said PLL sub-unit (340).

## Description

The invention relates to a demodulator, to a receiver, and to a method for demodulation of an input signal.

### BACKGROUND

In wireless transmission and also in transmission via a cable, a radio signal may be distorted in various ways. The distorted signal is then received by a receiver or demodulator or other signal processing device.

It is an object of the invention to provide a demodulator, receiver and method for demodulation allowing an improved demodulation of an input signal which may be distorted.

This object is solved by a demodulator according to claim 1, receiver according to claim 14, and method for demodulation according to claim 15.

Further details of the invention will become apparent form a consideration of the drawings and ensuing description.

### BRIEF DESCRIPTION OF THE SEVERAL VIEWS OF THE DRAWINGS

- Fig. 1: shows an exemplary scenario where a distorted signal is received by a television set;
- Fig. 2: shows a diagram of a received signal and different components thereof;
- Fig. 3: shows a demodulator according to an embodiment of the invention;
- Fig. 4: shows a PLL circuit according to a further embodiment of the invention;
- Fig. 5: shows a PLL filter according to a further embodiment of the invention;
- Fig. 6: shows main components of a demodulator according to a further embodiment of the invention;
- Fig. 7: shows main components of a demodulator according to a further embodiment of the invention;
- Fig. 8: shows a demodulator according to a further embodiment of the invention;
- Fig. 9: shows a television set according to a further embodiment of the invention;
- Fig. 10: shows a flowchart showing method steps of the method of demodulation according to a further embodiment of the invention.

### DETAILED DESCRIPTION

In the following, embodiments of the invention are described. It is important to note, that all described embodiments in the following may be combined in any way, i.e. there is no limitation that certain described embodiments may not be combined with others.

It should be noted that the following description shows mainly examples where a signal is transmitted via a wireless channel. There is, however, no limitation that the channel be a wireless channel. The explained principles are likewise applicable if the signal is transmitted via a cable.

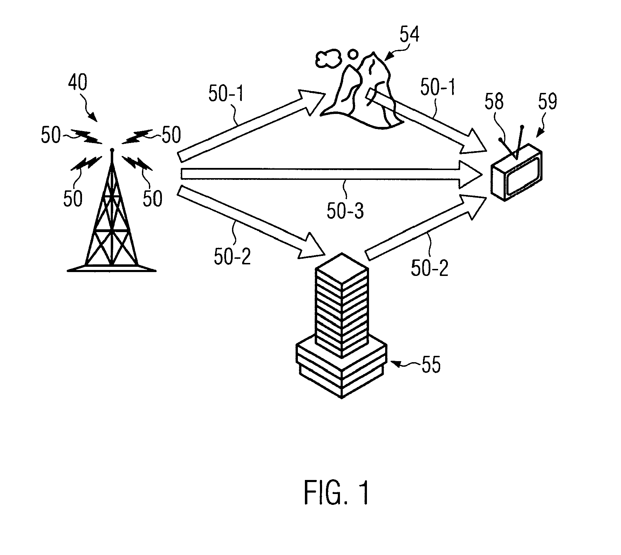

Fig. 1 shows a broadcast station 40 which may be e.g. a television broadcast station, broadcasting a television signal 50.

Television signal 50 may be received by an antenna 58 of a television set 59 of a user. However, antenna 58 may receive several parts of television signal 50, i.e. a first echo signal 50-1 of said television signal 50, a second echo signal 50-2 of said television signal 50 and a main path signal 50-3 of said television signal 50. The first echo signal 50-1 may have been caused by a first obstacle 54, e.g. a mountain. The second echo signal 50-2 may have been caused by a second obstacle 55, e.g. a building. The main path signal 50-3 is received by antenna 58 without having been reflected by any obstacle.

When demodulating the received signal 50-1, 50-2 and 50-3 in television set 59, the demodulated video picture may have picture distortions.

It is important to note that although Fig. 1 and the further description shows a television signal, all of the described embodiments of the invention may also be applied in other fields of radio communication, e.g. in satellite communication, when broadcasting/receiving a radio signal and various other fields where signals need to be demodulated that may comprise echoes. For example, the explained principles may also be applied to an orthogonal frequency division multiplex (OFDM) signal.

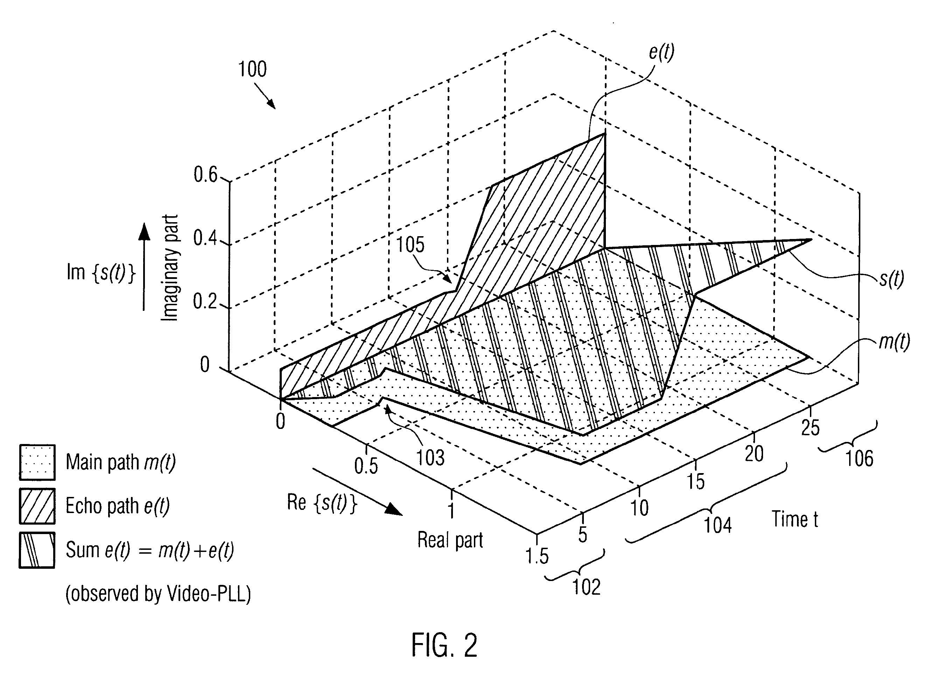

Fig. 2 shows a diagram 100 depicting a signal s(t) which may be received by a receiver. The signal s(t) may comprise a main path signal m(t) corresponding to a signal of a main path (e.g. signal 50-3 in Fig. 1) and an echo path signal e(t) corresponding to signal of an echo path (e.g. signals 50-1 and 50-2 in Fig. 1). Main path signal m(t) may, thus, have been received by receiver without having been reflected by any obstacles. Echo signal e(t) corresponds to an echoed version of main signal m(t) and may have been reflected by an obstacle.

Diagram 100 shows the real part Re{s(t)} and the imaginary part Im{s(t)} of signal s(t) corresponding to the sum of main path signal m(t) and echo signal e(t).

As shown in diagram 100, main path signal m(t) is a real signal, which in the example of Fig. 2 has a rather low amplitude in region 102 ranging from t = 1,5 to 5 and a rather high amplitude in region 104, 106 from t = 5 to t = 30. As can be seen, the amplitude of main path signal m(t) jumps from the rather low level to the high level at point in time 103 at t = 5.

The echo signal e(t) corresponding to an echo version of main path signal m(t) follows the signal path of main path signal m(t) with a certain delay. Further, as seen, echo signal e(t) comprises an imaginary part.

Because echo signal e(t) follows main path signal m(t) with a delay, the raise of the amplitude of the main path signal m(t) at point in time 103, occurs at a later point in time 105 at around t = 18.

Since signal s(t) corresponds to the sum of main path signal m(t) and echo signal e(t), signal s(t) changes at point in time 103 and at point in time 105. Since echo signal e(t) comprises an imaginary part, signal s(t) also comprises an imaginary part.

Signal s(t) may be received by a receiver comprising a phase locked loop. Nowadays, phase locked loops react very fast to a change of frequency and/or phase. Therefore, the PLL may try to follow frequency and/or phase of signal s(t). Consequently, after the PLL, the signal may exhibit fast time-varying phase changes which may lead to problems in the further processing within the receiver. If signal s(t) corresponds to a television signal, such problems may lead to picture distortions. The embodiments of the invention described below may avoid such problems.

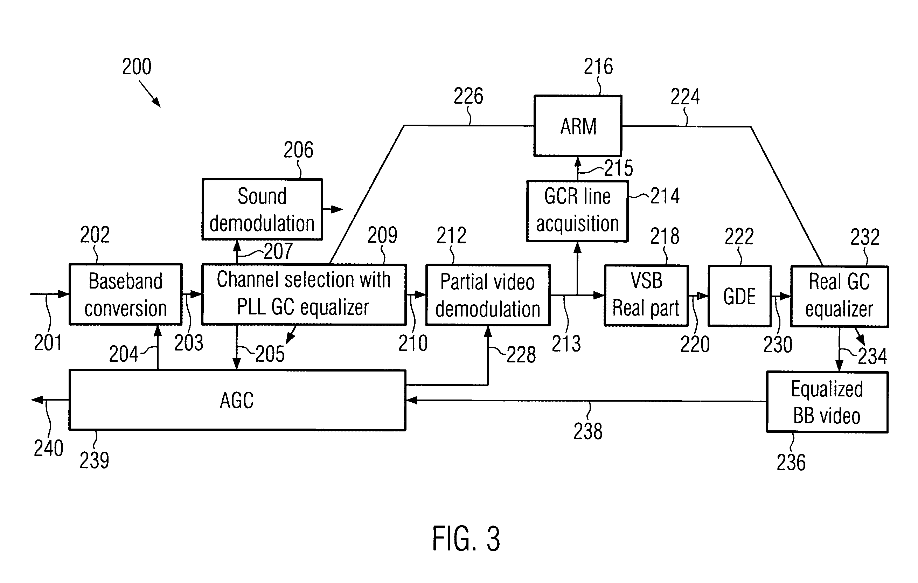

Fig. 3 shows a demodulator 200 comprising a base band converter 202, sound demodulator 206, phase locked loop (PLL) circuit 209, partial video demodulator 212, line acquisitor 214, advanced risc machine (ARM) 216, vestigial sideband real part filter 218, group delay equalizer 222, real ghost canceling equalizer 232, signal processor 236 and automatic gain controller (AGC) 239. It should be noted that instead of an advanced risc machine any other suitable data processor may be used.

Demodulator 200 has as input an input signal 201 which may e.g. correspond to an analogue television signal.

Base band converter 202 converts input signal 201 into a base band converted signal 203 which is a complex signal. Base band signal 203 may not yet exactly be at zero frequency and there may be an offset of e.g. +-100 Hz. This offset may be corrected by PLL circuit 209.

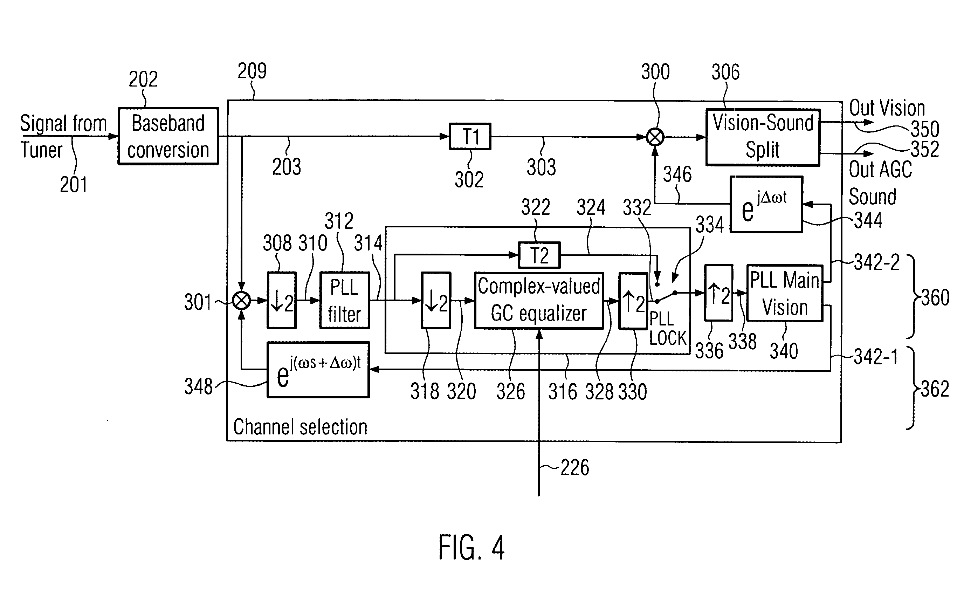

PLL circuit 209 comprises a complex-valued equalizer (not shown in Fig. 3, see Fig. 4) configured to equalize a derivative of base band signal 203 based on complex valued filter coefficients 226. PLL circuit 209 further comprises a vision sound splitter (not shown in Fig. 3, see Fig. 4) in order to generate a first sound signal 205 and second sound signal 207.

Further, PLL circuit 209 outputs a complex valued base band signal 210 which is fed to partial video demodulator 212 generating a complex valued signal 213. Complex valued signal 213 is fed into line acquisitor 214. If the input signal 201 Complex valued signal 213 is fed into line acquisitor 214. If the input signal 201 corresponds to a television signal, then line acquisitor 214 may e.g. determine lines comprising a reference signal such as e.g. a ghost canceling reference (GCR) signal. For example, in Japan, lines 18 and 281 of a television signal may comprise a ghost canceling reference signal. The output of line acquisitor 214 is a line information signal 215 comprising e.g. information about the line in which reference signals are transmitted.

Line information signal 215 is input into said advanced risc machine 216. Advanced risc machine 216 determines on the basis of line information signal 215 real filter coefficients 224 and complex valued filter coefficients 226. Note that line information signal 215 not only comprises line information but may also comprise the reference signals and/or a derivative of the reference signals in order to determine the filter coefficients 224, 226. For example, a derivative of the reference signals may be determined as a 4-field-difference signal GCR_F based on two reference signals GCR_A and GCR_B comprised in different lines of e.g. a television signal. The 4-field-difference signal GCR_F may be fed into advance risc machine 216 that determines filter coefficients 224, 226.

Filter coefficients 224, 226 may e.g. be determined based on a predetermined iterative algorithm for determining filter coefficients of adaptive filters. The advanced risc machine 216 may e.g. be realized as a field programmable gate array (FPGA) or as an ASIC.

Real filter coefficients 224 are then copied into a hardware register of real ghost canceling equalizer 232. Complex valued filter coefficients 226 are copied into a hardware register of complex-valued equalizer in PLL circuit 209. During copying/updating of the complex valued filter coefficients 226 in complex-valued equalizer 326, the PLL may be simply stopped to avoid any misbehavior of the PLL during coefficient update.

If input signal 201 is not a television signal but any other type of signal, then line acquisitor 214 may be configured to detect reference signals within said input signal 201, which reference signals are then used in said advanced risc machine 216 in order to determine filter coefficients 224, 226.

Complex valued signal 213 is further processed by a vestigial sideband filter and real part operation 218 outputting a real valued signal 220. Real valued signal 220 is then fed into group delay equalizer 222 in order to generate a group delayed equalized signal 230. Group delayed equalized signal 230 is used as input for said real valued ghost canceling equalizer 232. The output of real valued ghost canceling equalizer 232 is a real valued equalized signal 234 which may be processed in signal processor 236 and then fed into automatic gain controller 239. If input signal 201 is a television signal, then real equalized signal 234 corresponds to an echo equalized base band video signal. Automatic gain controller 239 finally outputs a gain controlled video signal 240.

It should be noted that PLL circuit 209 allows for channel selection, i.e. if e.g. a television channel is switched, then PLL circuit 209 tries to detect phase and exact frequency of the new channel.

Regarding PLL circuit 209 and real valued ghost canceling equalizer 232, it should be noted that these components allow for a real-time filtering.

Regarding the demodulator 200 of Fig. 3, it should further be noted, as is apparent from the above description, that the video signal is not equalized until after determining the real part. Thus, the unequalized video signal is available for determining filter coefficients 224, 226 via signal 213. It should be noted that throughout this specification, "equalizing" and "equalizer" refers to equalizing of channel distortions and to an equalizer configured to equalize channel distortions, respectively.

Fig. 4 shows PLL circuit 209.

PLL circuit 209 comprises a first multiplier 300, second multiplier 301, first delay unit 302, vision sound splitter 306, first decimator 308, PLL filter 312, second decimator 318, second delay unit 322, complex-valued equalizer 326, first sampling rate increaser 330, a first switch 334, a second sample rate increaser 336, a PLL sub-unit 340, a phase shifter 344, and a PLL correction signal processor 348. PLL sub-unit 340 is configured to generate a frequency correction signal 342-1 and a phase correction signal 342-2.

As explained above at hand of Fig. 3, base band converted signal 203 is used as input signal for PLL circuit 209. The base band converted signal 203 is delayed by first delay unit 302 generating a first delayed signal 303. The delay is chosen such that it corresponds to the delay caused by components 308, 312, 318, 326, 330, 336, 340, and 344.

As mentioned above, the complex valued filter coefficients 226 determined by the advanced risc machine 216 are copied into a hardware register of complex-valued equalizer 326.

The PLL circuit 209 comprises a forward path 360 and a feedback path 362. Forward path 360 comprises the first decimator 308, PLL filter 312, second decimator 318, complex-valued equalizer 326, first sampling rate increaser 330, first switch 334, second delay unit 322, second sample rate increaser 336 and PLL sub-unit 340. The feedback path 362 comprises PLL correction signal processor 348.

First decimator 308 and second decimator 318 each serve to decrease the sampling rate of the respective input signal. The sampling rate of the input signal to first decimator 308 may e.g. be reduced by one half. Thus, the sampling rate of first decimated signal 310 may be one half of that of base band converted signal 203. Second decimator 318 may further decrease the sampling rate by one half. Thus, the sampling rate of second decimated signal 320 may be one fourth of the sampling rate of base band converted signal 203.

Because the number of operations that need to be performed by the complex-valued equalizer 326 depend on the sampling rate, a low sampling rate of second decimated signal 320 leads to a low number of operations needed for equalizing by said complex-valued equalizer 326. The output of complex-valued equalizer 326 is a first equalized signal 328.

In the further processing, the sampling rate of first equalized signal 328 is increased by the first sampling rate increaser 330 and second sample rate increaser 336 leading to a second sample rate increased signal 338. The sampling rate of the second sample rate increased signal 338 corresponds to the sampling rate of base band converted signal 203.

It should be noted that the effort for increasing the sampling rate by the first sampling rate increaser 330 and second sample rate increaser 336 is in general low.

As seen in Fig. 4, complex equalizing unit 316 comprises a first processing path comprising second decimator 318, complex-valued equalizer 326 and first sampling rate increaser 330. Complex equalizing unit 316 further comprises a second processing path comprising second delay unit 322.

First switch 334 allows switching between first processing path and second processing path.

Switch 334 switches to the second processing path, if PLL circuit 209 is operated in an unlocked state, e.g. for a period of time shortly after the user has switched the channel, e.g. television channel.

If PLL circuit 209 is operated in a locked state, first switch 334 switches to the first processing path thus activating complex-valued equalizer 226.

It should be noted that the delay caused by second delay unit 322 corresponds to the delay caused by second decimator 318, complex-valued equalizer 326 and first sampling rate increaser 330 such that no differences exist with respect to delays depending on whether the first or second processing path is selected by first switch 334.

Due to the operation of complex-valued equalizer 326 on signal 320 with reduced sampling rate, the proposed complex-valued equalizer offers a low complexity as it solely compensates ghosts within the narrow band signal observed by the PLL.

The proposed embodiment of the invention, therefore, allow a complete compensation of complex-valued ghosts in analog television signals, a low complexity solution that is easy to migrate into existing solutions, an overall stable solution since input signals for filter coefficient computation is not equalized, and a filter coefficient update of the complex valued filter before the video PLL which leads to an easy handling by simply stopping the PLL during coefficient update.

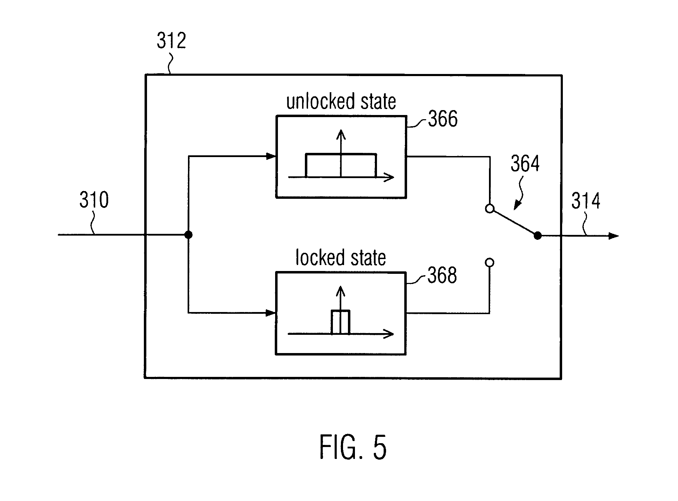

Fig. 5 shows PLL filter 312 comprising a second switch 364, broadband filter 366 and narrow band filter 368.

Second switch 364 allows for switching between broadband filter 366 and narrow band filter 368. The second switch 364 is, thereby, operated such that broadband filter 366 is applied, if PLL circuit 209 is operated in an unlocked state, and said narrow band filter 368 is applied, if the PLL circuit 209 is operated in a locked state.

For example, after a channel switch occurred, the PLL may be operated in the unlocked state, and by applying the broadband filter 366 the frequency range in which the PLL may be operated may be increased, e.g. the frequency range may correspond to ±200 Hz.

On the other hand, in the locked state, the narrow band filter 368 may reduce the frequency range of the PLL to ±100 Hz in a locked state.

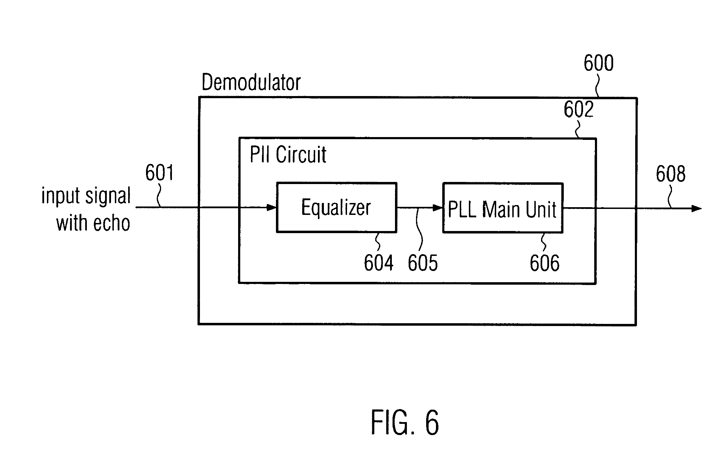

Fig. 6 shows a demodulator 600 as a further embodiment of the invention, which demodulator 600 is configured to demodulate an input signal 601 e.g. comprising an echo.

Demodulator 600 comprises a PLL circuit 602 which includes an equalizer 604 and PLL sub-unit 606. As depicted in Fig. 6, the output signal 605 of equalizer 604 is used as input signal for the PLL sub-unit 606. Equalizer 604 may e.g. allow for complex valued equalization of input signal 601. Thus, PLL sub-unit 606 may receive an echo-free signal 605 (signal 605 does not comprise a complex valued echo any more). Therefore, the PLL may not cause any distortions of the output video signal 608, which distortions could result because the PLL tries to compensate the angular changes resulting from the echo signal.

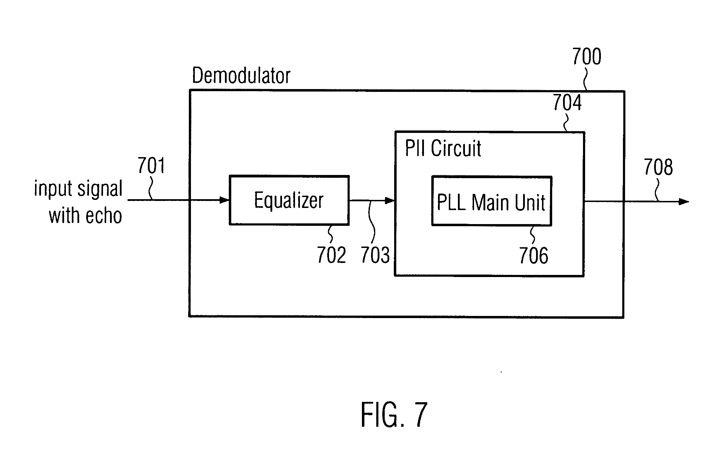

Fig. 7 shows a further embodiment of the invention. According to this embodiment, a demodulator 700 is provided comprising a complex-valued equalizer 702, and PLL circuit 704. PLL circuit 704 includes a PLL sub-unit 706. Input signal 701 may e.g. comprise echoes as explained above at hand of Fig. 2. These echoes are equalized by complex-valued equalizer 702 resulting in signal 703 which is used as input for PLL circuit 704. Because input signal 701 is equalized by complex-valued equalizer 702, the signal 703 used as input for PLL circuit 704 may be echo-free. Thus, also according to this embodiment, PLL circuit 704 may not cause any distortions of the video signal due to the echo.

As is clear from Fig. 7, according to this embodiment of the invention, the complex-valued equalizer is arranged before PLL circuit 704.

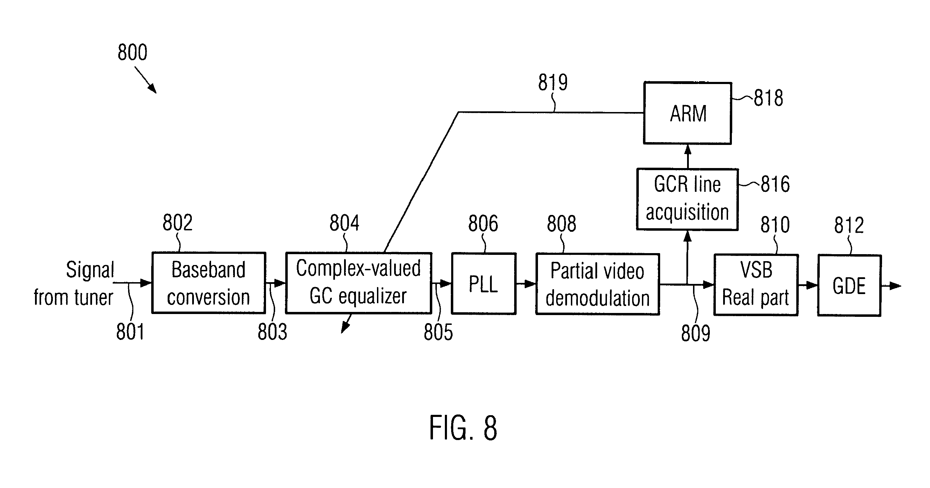

Fig. 8 shows a further embodiment of the invention. According to this embodiment, a demodulator 800 comprises a base band converter 802, complex-valued equalizer 804, PLL circuit 806, partial video demodulator 808, vestigial sideband real part filter 810, group delay equalizer 812, real valued ghost canceling equalizer 814, line acquisitor 816, and advanced risc machine 818.

An input signal 801 that may comprise an echo, is base band converted by base band converter 802 thereby generating a base band converted signal 803. Base band converted signal 803 is then processed by complex-valued equalizer 804 generating a filtered signal 805. Since complex-valued equalizer 804 equalizes echo signals included in base band converted signal 803, filtered signal 805 is free of echoes. Therefore, PLL circuit 806 may not be disturbed by any signal parts resulting from echoes that may be comprised within input signal 801. Before determining the real part of the video signal in vestigial sideband real part filter 810, complex video signal 809 is used as input for line acquisitor 816. Line acquisitor 816 may e.g. determine line information.

If the input signal 801 is a television signal, then line acquisitor 816 may e.g. determine the lines in which a ghost canceling reference signal is prevalent.

If input signal 801 corresponds to a signal other than a television signal, then line acquisitor 816 may comprise functionality to determine a reference signal comprised in the signal 809.

Advanced risc machine 818 determines complex valued filter coefficients 819 based on the line information and/or reference signals provided by line acquisitor 816.

Complex valued filter coefficients 819 are then fed into complex-valued equalizer 804 and are used for equalizing base band converted signal 803.

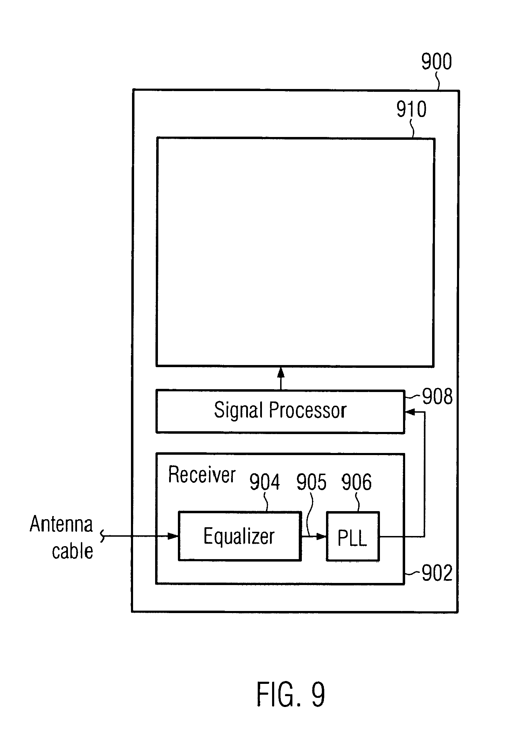

Fig. 9 shows a further embodiment of the invention according to which a television 900 comprises a receiver 902, complex-valued equalizer 904, PLL circuit 906, signal processor 908, and display 910.

Receiver 902 includes the equalizer 904 and PLL circuit 906.

Receiver 902 receives an input signal 901 that may comprise an echo. Complex-valued equalizer 904 equalizes the echo paths of the input signal 901, thus generating an equalized signal 905 corresponding to a video signal that is echo-free, i.e. an echo comprised in input signal 901 may have been removed.

Therefore, an echo-free signal 905 can be provided to PLL circuit 906.

The output signal of PLL circuit 906 may be further processed by signal processor 908 that generates a signal for controlling display 910. Because the PLL circuit 906 is not disturbed by any echoes, the picture displayed on display 910 may be free of any distortions e.g. caused by echo signals.

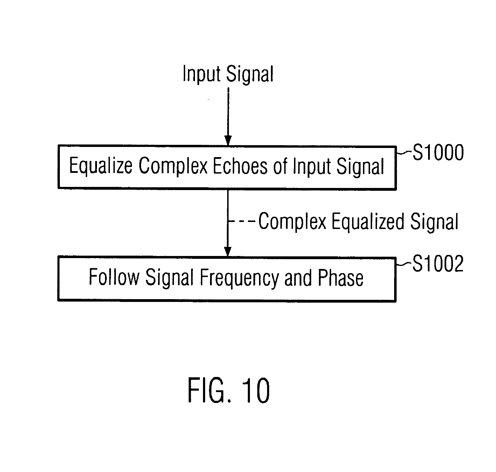

Fig. 10 shows a flowchart illustrating method steps for demodulating an input signal that may comprise echoes. In a first step S1000. complex valued echoes of the input signal are equalized. The result is a complex valued equalized signal. In step S1002, e.g. a PLL is used for following the signal frequency and phase of the complex valued equalized signal.

The following elucidations may help a person skilled in the art to get a better understanding of the invention:
In case of multi-path propagation (e.g. wireless television broadcast), a received television base band signal may be composed of several delayed and attenuated versions of the transmitted signal. However, the transmitted signal may be recovered by a channel-dependent equalization of the received signal. This equalization may be realized by a real-valued equalization of the demodulated television signal. However, this equalization approach may cause problems due to an imperfect video carrier phase recovery (video PLL) at an early stage of the demodulation process. As described above, therefore, a complex-valued equalization of the base band converted signal may be applied.

Multi-path propagation over wireless or wire-line channels may lead to unwanted echoes in the television signal. As shown in Fig. 1, the received television signal may be described by the superposition of several delayed and attenuated versions of the transmitted signal. After band-limitation and down-conversion the base band signal may be described by a main path and several complex-valued echoes which are identified as disturbances in the demodulated television signal.

## Claims

1. Demodulator for demodulating an input signal, comprising:
a complex-valued equalizer configured to equalize complex valued echoes within said input signal, wherein said complex-valued equalizer outputs a complex valued equalized signal;
a PLL circuit (209) including a PLL sub-unit (340) configured to generate a phase and/or frequency correction signal, wherein said complex valued equalized signal (336) or a derivative thereof is used as input signal for said PLL sub-unit (340).

2. Demodulator according to claim 1, comprising a processor (ARM) configured to determine complex valued filter coefficients of said complex-valued equalizer based on said complex valued equalized signal.

3. Demodulator according to claim 2, comprising a line acquisitor configured to determine line information based on said complex valued equalized signal, wherein said processor determines said complex valued filter coefficients based on said line information.

4. Demodulator according to any of the preceding claims, wherein said PLL circuit (209) includes at least one decimator configured to reduce the sampling rate of said input signal and to generate a decimated signal, wherein said complex-valued equalizer determines said complex valued equalized signal based on said decimated signal.

5. Demodulator according to any of the preceding claims, wherein said complex-valued equalizer is only operated if said PLL circuit is operated in a locked state.

6. Demodulator according to any of the preceding claims, wherein said PLL circuit includes a forward path comprising
a first processing path comprising said complex-valued equalizer and a second processing path;
a switch configured to switch between said first and second processing path, wherein, if said PLL circuit is operated in a locked state, said switch switches to said first processing path, and, if said PLL circuit is operated in an unlocked state, said switch switches to said second processing path.

7. Demodulator according to claim 6, wherein said second processing path comprises a delay mechanism (322) configured to cause a delay, wherein said delay is essentially equal to the delay caused by components in said first processing path.

8. Demodulator according to any of claims 6 or 7, wherein a first decimator (318) of said at least one decimator is arranged in said first processing path before said complex-valued equalizer.

9. Demodulator according to claim 8, wherein said first processing path comprises an sampling rate increaser (330) which is arranged after said complex-valued equalizer, wherein said sampling rate increaser is configured to increase the sampling rate of said complex valued equalized signal to the same sampling rate of the signal which is input into said one of said at least one decimator.

10. Demodulator according to any of claims 6 to 9, wherein said forward path comprises a further switch configured to switch between a broadband filter and a narrowband filter, said further switch and broadband and narrowband filter being arranged before said complex-valued equalizer, wherein, if said PLL circuit is operated in a locked state, said switch switches to said narrowband filter, and, if said PLL circuit is operated in an unlocked state, said switch switches to said broadband filter.

11. Demodulator according to claim 10, wherein said forward path comprises a second decimator of said at least one decimator, which second decimator is arranged before said further switch.

12. Demodulator according to any of the preceding claims, wherein said input signal is an analogue television signal.

13. Demodulator according to claim 1, comprising
a base band converter, wherein said complex-valued equalizer is arranged between said base band converter and said PLL circuit.

14. Receiver comprising a demodulator according to any of claims 1 to 13.

15. Method for demodulation of an input signal, comprising:
equalizing complex valued echoes within said input signal;
generating a complex valued equalized signal as a result of said step of equalizing;
following the signal frequency and phase of said input signal using a PLL circuit which includes a PLL sub-unit configured to generate a phase and/or frequency correction signal, wherein said complex valued equalized signal or a derivative thereof is used as input signal for said PLL sub-unit (340).

16. Method according to claim 15, comprising
determining complex valued filter coefficients based on said complex valued equalized signal, wherein said complex valued filter coefficients are applied in said step of equalizing.

17. Method according to claim 16, comprising
acquisition of line information based on said complex valued equalized signal, wherein said complex valued filter coefficients are determined based on said line information.

18. Method according to any of claims 15 to 17, comprising reducing the sampling rate of said input signal,
generating a decimated signal based on said step of reducing the sampling rate,
determining said complex valued equalized signal based on said decimated signal.

19. Method according to any of claims 15 to 18, wherein said step of equalization is only performed if said PLL circuit is operated in a locked state.

20. Method according to any of claims 15 to 19, wherein said input signal is an analogue television signal.

21. A computer program product including computer program instructions that cause a computer to execute a method for demodulation of an input signal, comprising:
equalizing complex valued echoes within said input signal;
generating a complex valued equalized signal as a result of said step of equalizing;
following the signal frequency and phase of said input signal using a PLL circuit which includes a PLL sub-unit configured to generate a phase and/or frequency correction signal, wherein said complex valued equalized signal or a derivative thereof is used as input signal for said PLL sub-unit (340).

22. Receiver for receiving and demodulation of an analogue television signal, comprising:
an equalizer configured to equalize complex valued echoes within said input signal, wherein said equalizer outputs a complex valued equalized signal;
a PLL circuit (209) including a PLL sub-unit, wherein said complex valued equalized signal (336) or a derivative thereof is used as input signal for said PLL sub-unit (340).

23. Receiver for receiving and demodulation of an analogue television signal, comprising:
an equalizer configured to equalize complex valued echoes within said input signal, wherein said equalizer outputs a complex valued equalized signal;
a PLL circuit (209) including a PLL sub-unit, wherein said complex valued equalized signal (336) or a derivative thereof is used as input signal for said PLL sub-unit (340), and wherein said PLL circuit comprises a forward path comprising a first decimator, said equalizer and a second decimator.

24. Receiver for receiving and demodulation of an analogue television signal, comprising:
an equalizer configured to equalize complex valued echoes within said input signal, wherein said equalizer outputs a complex valued equalized signal;
a PLL circuit (209) comprising a forward path including in the order of signal processing
a first and second decimator each configured to decrease the sampling rate of the television signal,
said equalizer,
a first and second sampling rate increaser each configured to increase the sampling rate of the television signal.

25. Method for demodulation of an input signal, comprising:
equalizing complex valued echoes within said input signal;
generating a complex valued equalized signal as a result of said step of equalizing;
following the signal frequency and phase of said input signal using a PLL circuit, wherein said complex valued equalized signal or a derivative thereof is used as input signal for said PLL circuit.

26. Means for demodulation of an input signal, comprising:
means for equalizing complex valued echoes within said input signal;
means for generating a complex valued equalized signal as a result of said step of equalizing;
means for following the signal frequency and phase of said input signal using a PLL circuit which includes a PLL sub-unit configured to generate a phase and/or frequency correction signal, wherein said complex valued equalized signal or a derivative thereof is used as input signal for said PLL sub-unit (340).
